# EUROPEAN PATENT SPECIFICATION

(11) **EP 4 434 122 B1**
(45) Date of publication and mention of the grant of the patent: **05.11.2025**
(21) Application number: 22793837.0
(22) Date of filing: 26.09.2022
(51) Int. Cl.: H05K 3/36, H05K 3/00, H01R 12/73, H01R 13/6594, H01R 13/6587, H01R 13/453

(54) **SINGLE-PIECE HIGH DATA RATE BACKPLANE CONNECTOR**
EINTEILIGER RÜCKWANDPLATINENVERBINDER MIT HOHER DATENRATE
CONNECTEUR DE FOND DE PANIER MONOBLOC À HAUT DÉBIT DE DONNÉES

(30) Priority: 27.09.2021 US 202163248553 P; 30.11.2021 US 202163284600 P
(43) Date of publication of application: 25.09.2024
(73) Proprietor: MINDREACH i2i, SL, Andorra La Vella, AD500 (AD); MINDRECI, Gaby Cristian, 31820 Pibrac (FR)
(72) Inventor: POPSOR, Eduard, Maple, Ontario L6A 2H3 (CA); MINDRECI, Gaby Cristian, 31820 Pibrac (FR)
(74) Representative: Sahuquillo Huerta, Jesús
(86) International application number: PCT/IB2022/059139
(87) International publication number: WO 2023/047377

(56) References cited:
- EP-A2- 3 399 597
- DE-A1- 102005 003 581
- US-A- 3 651 444
- US-A1- 2005 101 188

## Description

### FIELD OF THE INVENTION

This invention relates generally to electrical connectors and more specifically to high-speed backplane connectors systems which are used in telecommunications in industrial, scientific, aerospace and space-flight fields. This single-piece connector is designed to conform with the requirements of Compact PCI Serial Space Specification CPCI-S.I R1.0 released by PICMG on August 4, 2017.

### BACKGROUND

There are several high-speed backplane connector systems known in the State of Art to connect a first printed circuit board or mother board with a second printed circuit board or daughter board. Since electronic components become more reduced and computing power highly scalable, the existing high-speed backplane connectors include several configurations to optimize data transmission.

For example, well-known configurations may include connector systems with a plurality of wafer assemblies defining a mating end and a mounting (or termination) end, where the mating ends include two mating elements generally referred to as male to female or pin to socket, defining a dual connecting interface generally known as a mating pair. In these systems, one mating element's terminations mate with the daughter board and the other mating element's terminations mate with the mother board or backplane. During the connection of daughterboard or daughter card to mother card or backplane, the two elements mate together, and the connection is called an insertion point in the signal transmission line. Consequently, the mechanical and electrical fittings at the insertion point affect the signal path and therefore the signal integrity performance.

US2005/101188A1 provides a high-speed electrical interconnection system designed to overcome the drawbacks of conventional interconnection systems. In preferred embodiments, the present invention provides an electrical connector capable of handling high-speed signals effectively.

EP3399597A2 discloses a float connector for interconnecting printed circuit boards that comprises a contact assembly including a plurality of contacts and a holder configured to axially support the contacts, each of the plurality of contacts having opposite first and second contact ends for electrically connecting to the printed circuit boards; a first guide member slidably and flexibly coupled to the holder of the contact assembly, the first guide member having a plurality of first openings corresponding to each of the first contact ends, respectively; a second guide member slidably and flexibly coupled to the holder of the contact assembly, the second guide member having a plurality of second openings corresponding to each of the second contact ends, respectively; and a biasing member disposed between the first and second guide members, the biasing member biasing the first and second guide members away from one another to an open position. When the first and second guide members are in an open position, the first and second contact ends are recessed in the first and second guide members, respectively, and not exposed. The first and second guide members are movable from the open position to a compressed position in which the biasing member is compressed to expose the first and contact second ends outside of the openings of the first and second guide members, respectively.

US3651444A discloses an electrical connector adapted to receive a mating connector is mounted on panelboard having terminal posts therein. Holes in the connector receive the ends of the terminal posts and connector is resiliently biased above the surface of panelboard so as to protect the posts. Upon engagement with the mating connector, the connector moves downwardly towards the surface of the panelboard, the posts move relatively through the holes and enter contact sockets in the mating connector.

Finally, DE102005003581A1 describes an electrical plug having a cover attached over pins of an electrical plug. The cover is held at a plug body and covers all the pins. The cover includes a through hole (8) for each pin of the plug. The pins are all around un-removably held in the hole in its position. The body includes a free space for receiving the cover. The pins are inserted into the hole, such that the pins are integrated into the body in an end position.

### SUMMARY OF THE INVENTION

This invention describes an improved daughterboard or daughter card to backplane connector designed to operate at speeds over 25 Gbps comprised into a single piece or unibody configuration according to claim 1 that eliminates the typical male to female or pin to socket insertion point. As a result, the signal path matches more closely the same path geometry that is found on the daughter card and on the backplane permitting superior signal integrity, impedance matching and lower losses through the signal transmission line from source to destination.

Moreover, the single-piece backplane connector includes a guiding and automatically retracting cover which protects the mating pins on the backplane side and aligns them immediately prior to interfacing with the via orifices into the backplane therefore providing an enhanced mechanical fitting. The invention employs materials and features already proven to meet the performance requirements for harsh environments, specifically for space-flight applications according to the European Space Agency's relevant ESCC specifications.

The contact terminations on both sides of the connector are treated with electrodeposited gold finish and for a first embodiment are employing a low-force interface design known as "the twist-pin" allowing the terminations to be rated at over 200 low-force insertion-removal cycles preserving gold plating integrity on both termination and via wall and further eliminating any concern for deformation or stress into the metallized via and surrounding printed circuit board material.

For a second embodiment, the contact terminations on both sides of the connector are also treated with electrode posited gold finish and are employing an interface design known as Slide-Fit Electrical Contact Termination Technology based on US Provisional Application No. 63/284,600, which is hereby incorporated by reference in its entirety.

The entire connector in both embodiments, in accordance with the present invention, is FFF (fit, form, function) compliant with the compact PCI Serial architecture therefore backward compatible allowing for quick integration and deployment in current applications.

### BRIEF DESCRIPTION OF THE DRAWINGS

The accompanying drawings are not intended to be drawn to scale. In the drawings:
- FIG. 1 is a perspective view showing exemplary six single-piece backplane connectors, in accordance with a first embodiment of the present invention, in a daughterboard to backplane connection system illustrating an environment in which the invention may be applied.
- FIG. 2A and 2B are perspective views of the single-piece backplane connector in accordance with a first embodiment of the present invention, in an unpressed position, where only the pins on the daughterboard side are visible and the pins on the backplane side are hidden by the protective cover.
- FIG. 3A and 3B are exploded views of the single-piece backplane connector, in accordance with a first embodiment of the present invention.
- FIG. 4A is a perspective view of the staggered body assembly of the single-piece backplane connector, in accordance with a first embodiment of the present invention.
- FIG. 4B is an exploded view of the staggered body assembly of the single-piece backplane connector, in accordance with a first embodiment of the present invention.
- FIG. 5 is a side view of the staggered body assembly of the single -piece backplane connector, in accordance with a first embodiment of the present invention.

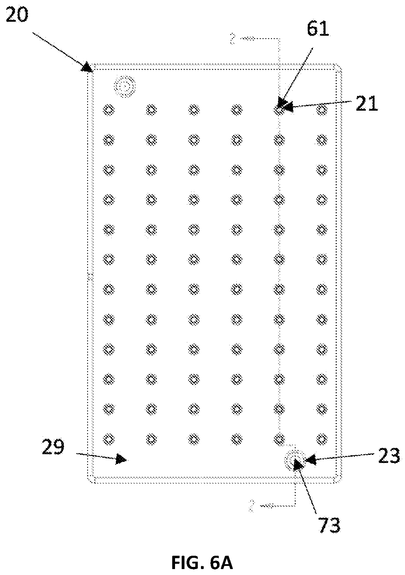

- FIG. 6A is a front view of the single-piece backplane connector, in accordance with a first embodiment of the present invention.

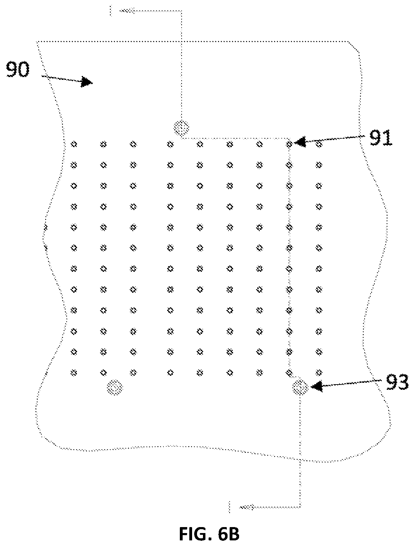

- FIG. 6B is a front view of a portion of the backplane mating with the single-piece backplane connector, in accordance with a first embodiment of the present invention.
- FIG. 7A is a cross-sectional representation of the single-piece backplane connector illustrated in FIG. 6A, taken along the line 2-2 with the sliding cover in an unpressed position with the cover in the active protection position.
- FIG. 7B is a cross-sectional representation of the single-piece backplane connector illustrated in FIG. 6A, taken along the line 2-2 with the sliding cover in a pressed or connected position.
- FIG. 8A is a cross-sectional representation of the portion of the backplane mating with the single-piece backplane connector illustrated in FIG. 6B, taken along the line I-I with the sliding cover, before mating and the sliding cover in an unpressed position. FIG. 8B is a cross-sectional representation of the portion of the backplane mating with the single-piece backplane connector illustrated in FIG. 6B, taken along line I-I with the sliding cover, starting to mate and the sliding cover in an unpressed position.
- FIG. 8C is a cross-sectional representation of the portion of the backplane mating with the single-piece backplane connector illustrated in FIG. 6B, taken along the line I-I with the sliding cover, with a complete mating and the sliding cover in a pressed position.
- FIG. 8D is an enlarged detailed view of the area selected in FIG. 8C of the twist pins used in the manufacture of the single -piece backplane connector, in accordance with one embodiment of the present invention.
- FIG. 9 is a perspective view showing exemplary six single-piece backplane connectors of two different sizes, in accordance with a second embodiment of the present invention, in a daughterboard to backplane connection system illustrating an environment in which the invention may be applied.
- FIG. 10A, 10B and 10C are perspective views of the single-piece backplane connector in accordance with the second embodiment of the present invention, in unmounted position, where only the pins on the daughterboard side are visible and the pins on the backplane side are hidden by the protective cover.
- FIG. 11A and 11B are exploded views of the single -piece backplane connector, in accordance with the second embodiment of the present invention.
- FIG. 12A is a perspective view of the staggered body assembly of the single-piece backplane connector, in accordance with the second embodiment of the present invention.
- FIG. 12B is an exploded view of the staggered body assembly of the single-piece backplane connector, in accordance with the second embodiment of the present invention taken from an angle looking towards the side mating with the backplane.
- FIG. 12C is a perspective view of one exemplary locking lever of the staggered body assembly of the single-piece backplane connector, in accordance with the second embodiment of the present invention.
- FIG. 12D is an exploded view of the staggered body assembly of the single-piece backplane connector, in accordance with the second embodiment of the present invention taken from an angle looking towards the side mating with the daughterboard.
- FIG. 13A is a portion of an exploded view showing a spring mechanism of the protective cover used in the second embodiment of the present invention.
- FIG. 13B is a magnified perspective view of a return spring.
- FIG. 14A is a cross-section view showing the second embodiment of the single piece connector aligned with the footprint of the daughterboard PCB in the first step of the installation sequence of the connector onto the respective printed circuit board.
- FIG. 14B is a cross-section view showing the second embodiment of the single piece connector inserted into the daughterboard PCB footprint without any resistance or installation tools, as the second step of the installation sequence of the connector onto the respective printed circuit board.
- FIG. 14C is a cross-section view showing the second embodiment of the single piece connector inserted and locked into the daughterboard PCB footprint, an action achieved by the activation of the locking screw, as the third and last step of the installation sequence of the connector onto the respective printed circuit board.
- FIG. 15A is a perspective view of a cross-section showing the first step in the blind-mating operation between the second embodiment of the single piece connector and the backplane PCB.
- FIG. 15B is a perspective view of a cross-section showing the second step in the blind-mating operation between the second embodiment of the single piece connector and the backplane PCB.
- FIG. 15C is a perspective view of a cross-section showing the third and last step in the blind-mating operation between the second embodiment of the single piece connector and the backplane PCB.
- FIG. 15D shows on the left a perspective view of the dielectric portion of the protective slide-fit cover and on the right, it shows a magnified cross-section through the center of the cavities designed to achieve the offset for the slide-fit contacts.

### DETAILED DESCRIPTION

Embodiments of a single-piece high data rate backplane connector, and system are described herein. In the following description numerous specific details are set forth to provide a thorough understanding of the embodiments. However, a person skilled in the relevant art will recognize that the techniques described herein can be practiced without one or more specific details, or with other components, materials, etc.

In the sake of clarity, a reference description of each numbered technical feature or element from the figures can be found in the following table 1 :

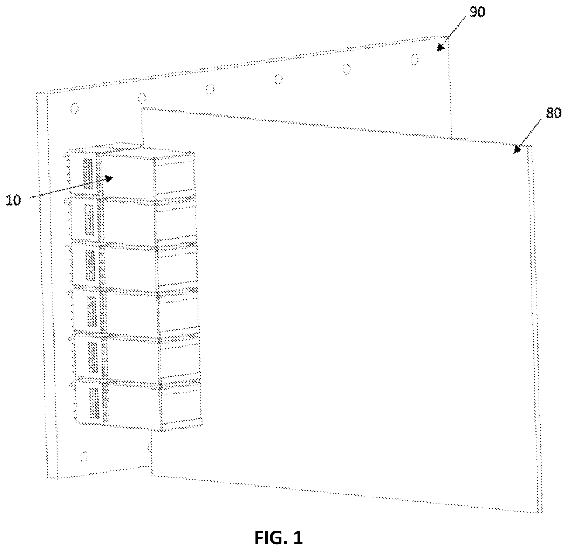

The single-piece backplane connector in accordance with the first embodiment of the present invention includes the relevant technical features as listed below: FIG. 1 is a perspective view showing six single-piece backplane connectors (10) in accordance with a first embodiment of the present invention. Each of the single-piece backplane connectors (10) mates directly in self-aligning blind mating operation with a backplane PCB (90) in its front end, hereby referred as "backplane side"; and mates directly with a daughterboard PCB (80) in its bottom, hereby referred as "daughterboard side". Generally, the single -piece backplane connectors (10) are inserted into and extracted from the backplane PCB (90) with certain cycling frequency, while the attachment to the daughterboard PCB (80) is generally maintained since original installation. However, the special characteristics of this invention permit multiple installation and removal cycles onto the daughterboard PCB (80) without damaging plated holes, allowing the connector to be reusable or recyclable. The backplane PCB (90) and the daughterboard PCB (80) are well-known components of the state of the art.

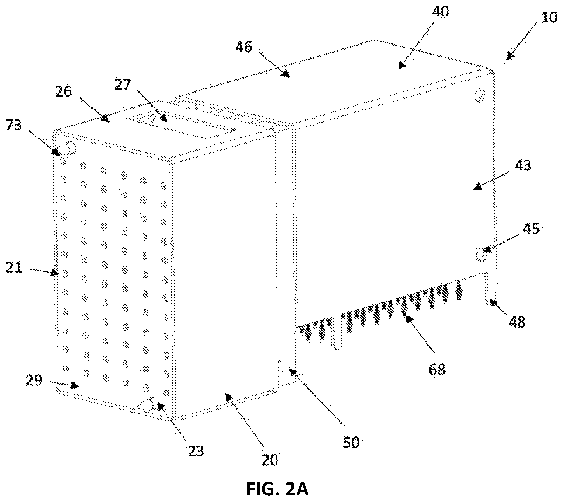

As illustrated in FIGS. 2A to 3B, the single-piece backplane connector (10) comprises a protective sliding cover (20), an EMI shielding housing (40), and a staggered body assembly (50). The sliding cover (20) slidably attaches and protects a front portion of the staggered body assembly (50), while the EMI shielding housing (40) fixedly protects a rear portion of the staggered body assembly (50).

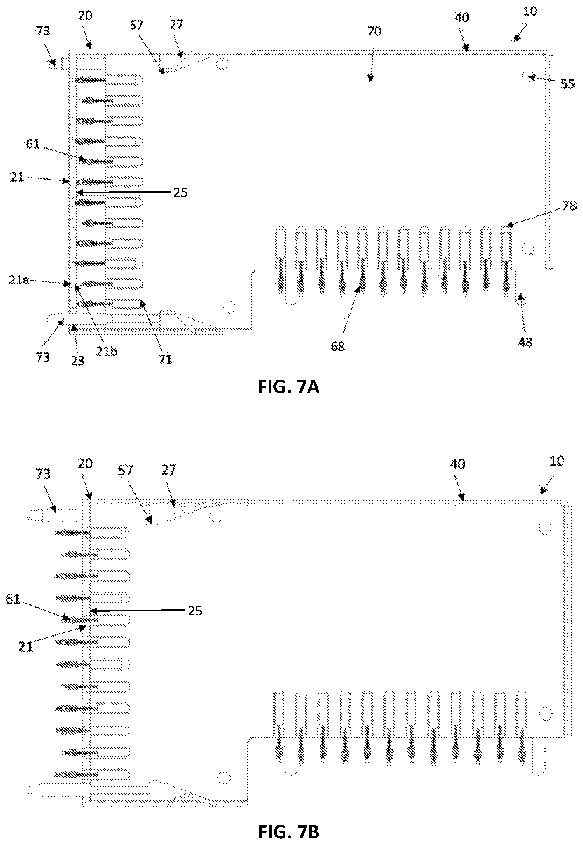

The protective sliding cover (20) has a front face (29) comprising a plurality of pin contact orifices (21) and at least two guide orifices (23). In the illustrated embodiment, the pin orifices (21) are conformed by a cylindrical portion (21a) in the front face (29) and a conical portion (21b) in the rear face (25) of the protective sliding cover (20), as can be better observed in FIGS. 7 A and 7B and will be explained in detail further in this description. In addition, the top face (26) of the sliding cover and the bottom face (28) of the sliding cover include an integrated spring clip (27) to allow the protective sliding cover (20) to return from a pressed position to a protected unpressed or disconnected position, as will be explained later in this description. Each of the plurality of pin orifices (21) permit the path through of a corresponding plurality of twist pin contacts (61) located in the front portion of the staggered body assembly (50). Similarly, at least two guide orifices (23) permit the path through of at least two corresponding guide pins (73) located in the front portion of the staggered body assembly (50) wherein the at least two guide pins (73) align the single-piece backplane connector (10) with the backplane PCB (90) during bling-mating engagement.

Moreover, as illustrated in FIGS. 2A to 3B, the EMI Shielding housing (40) of the single -piece connector (10) preferably comprises a top surface (46), a rear wall (49) and two lateral walls (43, 44). Each of the lateral walls (43, 44) is extended into the daughterboard side by at least one shield tail (48) and at least one installation orifice (45). In the illustrated embodiment, the EMI Shielding housing (40) has four installation orifices (45) and four staggered shield tails (48) to fully separate the mechanical function from the electrical function of the device during the mating action and during the operation of the equipment. The separation of the mechanical function from the electrical function ensures that no mechanical stress is imparted to the contacts whose function remain only as electrical connections. The four shield tails (48) allow the transfer of mechanical load during the insertion and extraction of the daughterboard PCB (80) and therefore effectively relieving mechanical load to the electrical contacts allowing the contacts to perform only the electrical function.

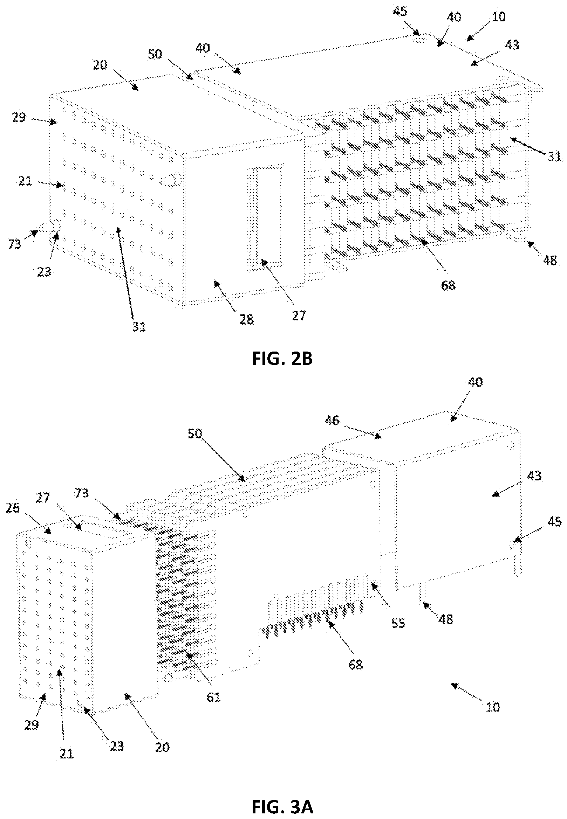

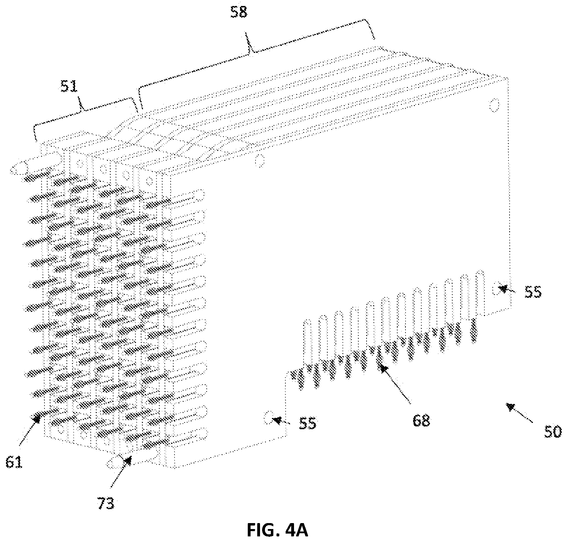

As depicted in FIGS. 3 A to 5, the single-piece backplane connector (10) includes the staggered body assembly (50) which is a wafer assembly of connector body built from a plurality of alternating PCB layers (60) and dielectric spacers (70). Each of the PCB layers (60) and dielectric spacers (70) include at least one installation orifice (55) to support the assembly. Also, each of the PCB layers (60) and dielectric spacers (70) is outlined to define a frontal portion (51) and a rear portion (58), as indicated in FIG. 4A. In the illustrated embodiment, each of the PCB layers (60) and dielectric spacers (70) have four installation orifices (55). In addition, in the illustrated embodiment, the frontal portion (51) includes a top and bottom groove (57) to interact with the integrated spring clip (27). Moreover, at least two of the dielectric spacers (70) include the corresponding at least two guide pins (73) on the backplane side.

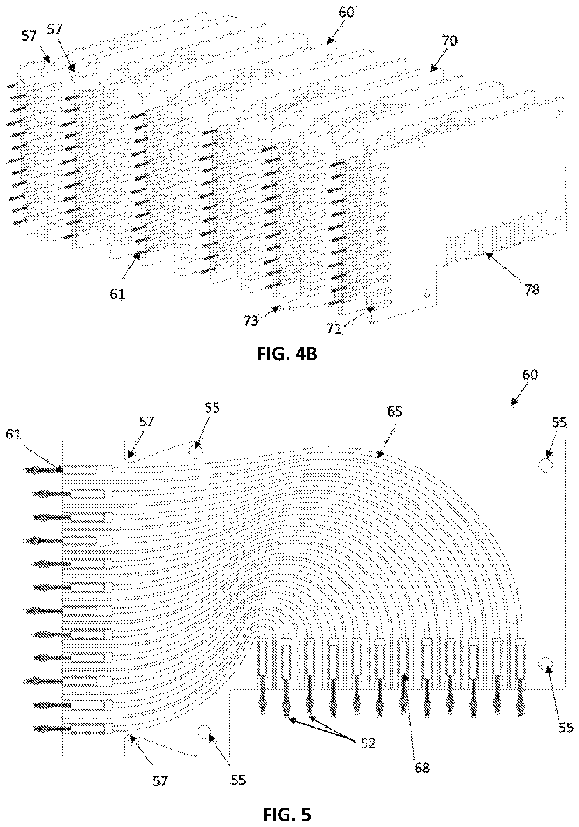

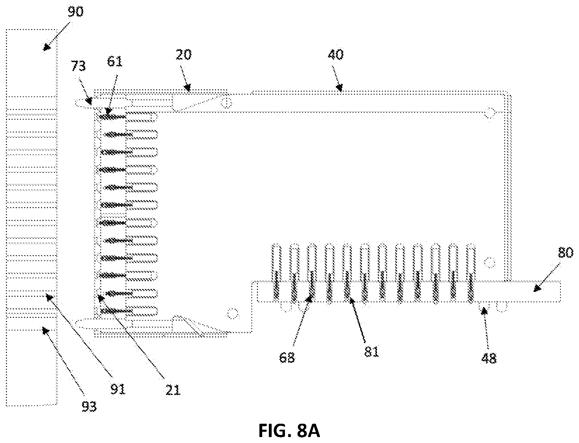

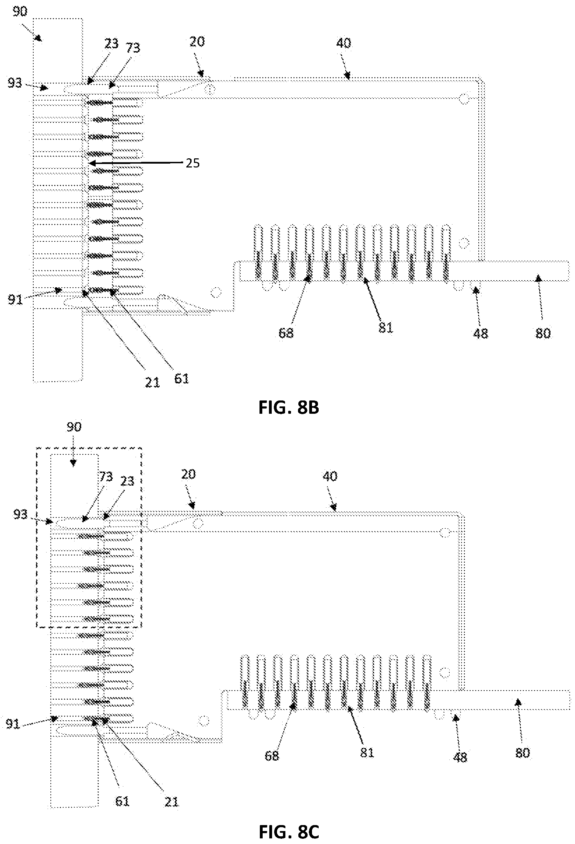

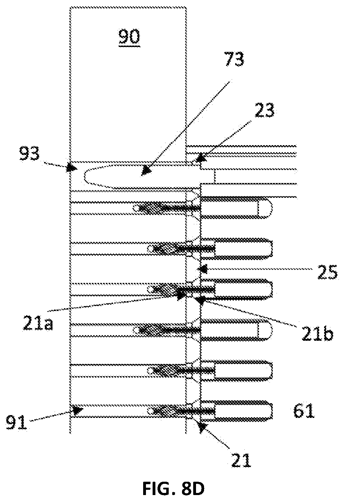

Referring to FIG. 5, each of the PCB layers (60) has a plurality of traces (65), wherein each trace (65) electrically connects each twist pin contact (61) on the backplane side with a corresponding twist pin contact (68) on the daughterboard side. The preferred embodiment of the invention includes an alternating offset arrangement (52) of the twist pin contacts (68) on the daughterboard side to shift the piercing moment for 50% of the twist pin contacts (68) during the press-fit application, therefore effectively reducing the total insertion force of the device into the daughterboard PCB (80). Moreover, as illustrated in FIG. 4B, each of the dielectric spacers (70) include a plurality of slots (71) on the backplane side and a plurality of slots (78) on the daughterboard side, each one corresponding to the position of each twist pin contact (61 , 68) on both the backplane side and daughterboard side. The selected twist pin contact configuration of pin contacts (61) and (68) represent one embodiment of the invention, however the contacts tip interface geometry may employ different configurations to achieve reliable electrical contact with a plurality of plated through holes (81) in the daughterboard PCB (80) and a plurality of plated through holes (91) backplane PCB (90), as shown in FIGS. 8A to 8C. The combination of the construction shown in FIGS. 4B and 5, within the same assembly of PCB layers (60) with contact pins (61, 68) welded on both ends of PCB traces (65) and separated by dielectric spacers (70) to assure alignment and isolation, is a construction arrangement employed for the first time to allow the creation of a direct PCB-to-PCB connector body utilizing a completely novel method in contrast to the existing technologies where molded insulators house individual contacts routed through cavities. It should be considered within the scope of this invention that configurations of the traces (65) within the PCB layers (60) may vary depending on technical requirements of the connector.

FIGS. 8A to 8D show the process of blind mating the connector assembled on the daughterboard PCB (80) with the footprint in the backplane PCB (90). In FIG. 8B the at least two guide pins (73) align the connector with the backplane during the insertion process which takes place from right to left of the image. The at least two guide pins (73) help preventing the sliding cover (20) to start moving backwards unless they find at least two corresponding guiding orifices (93) in the backplane PCB (90). The guide pins (73) fully align the connector assembled on the daughterboard PCB (80) with the backplane PCB (90), so that the front face (29) of the protective sliding cover (20) makes a flat connection with the surface of the backplane PCB (90), and only when in correct position it starts sliding towards the body of the single-piece connector (10) permitting the twist pin contacts (61) to protrude through the pin orifices (21) and start mating with the corresponding plurality of plated through holes (91) in the backplane PCB (90). In addition, the rear face (25) of the protective sliding cover (20) employs the conical portion (21b) to ensure a second level of precision guiding for each individual twist pin contact (61) to prevent the stubbing of the contacts. This second level of alignment for the contacts is an innovative feature never employed in prior art pertaining to the blind mating operation of electrical connectors.

As described in FIGS. 7A and 7B, the present invention also includes an automatic return mechanism on the protective sliding cover (20) with the integrated spring (27). Preferably, the shield which contains spring is manufactured in beryllium-copper due to the good elastic properties of the material. The integrated top and bottom spring clips (27) ensure that the protective sliding cover (20) automatically returns in the disconnected position which fully protects the twist pin contacts (61) by shrouding them completely when the connector is uncoupled from the backplane PCB (90).

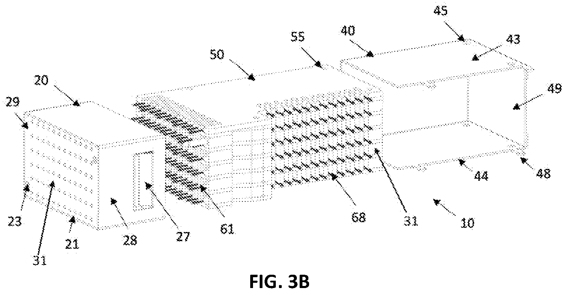

The single-piece backplane connector (10) features flat surfaces (31) on the dielectric materials which come into contact with the surfaces of the daughterboard PCB (80) and the backplane PCB (90) as seen in FIGS. 2B and 3B, in order to satisfy the "double-insulation" requirement present in ESCC specifications related to connectors destined for space-flight applications.

This invention replaces traditional two gender (male and female) mating connectors configurations where one connector is installed on the daughterboard PCB (80) and its counterpart connector is installed on the backplane PCB (90). Therefore, the single-piece connector (10), consists of one single part number instead of two distinct part numbers. The main advantage is that the high-speed signal is maintained in superior quality through the transmission line within the connector since this invention eliminates the insertion point created by the interface between the two gender connectors.

A second embodiment of the present invention will be described in the following paragraphs. For the second embodiment, the contact terminations on both sides of the connector employ a specific interface design between connector and PCBs, known as Slide-Fit Electrical Contact Termination Technology based on US Provisional Application No. 63/284,600, which is hereby incorporated by reference in its entirety. Component items featured with a triple digit designation are particular to the second embodiment of the invention and in some occurrences where the second and third digits of the number coincide with the first and second digit of the items described in the first embodiment, a redundant detailed description may be avoided due to similarities with the first embodiment.

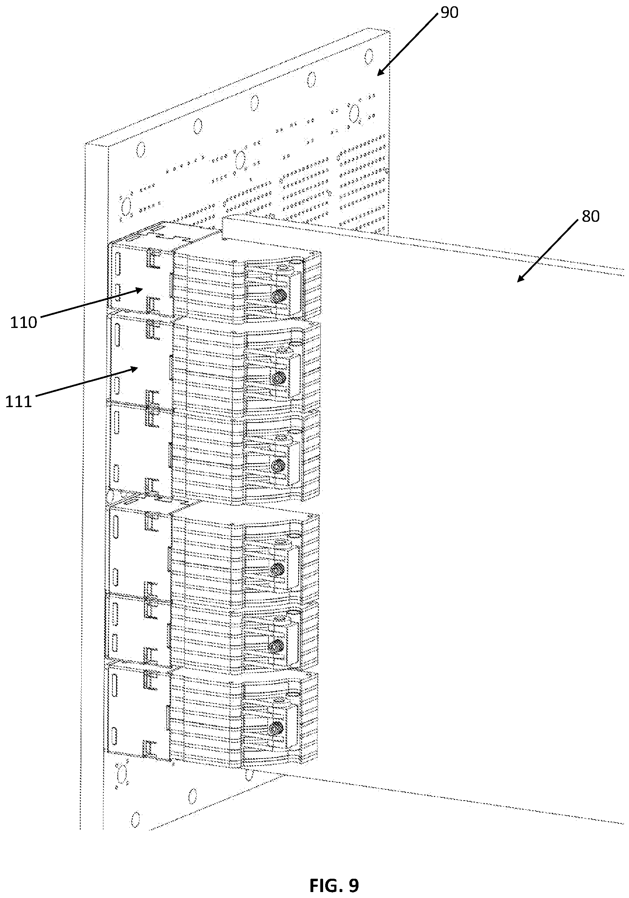

Similarly to the first embodiment described above, single-piece backplane connectors of the second embodiment shown installed on the daughtercard PCB (80) and plugged into the backplane PCB (90) in FIG. 9, is depicted in perspective view, showing exemplary single-piece backplane connectors of two different sizes, three single-piece backplane connectors (110) with 6 rows of contacts which appear narrower in the image, and three single-piece backplane connectors (111) with 8 rows of contacts which appear wider in the image.

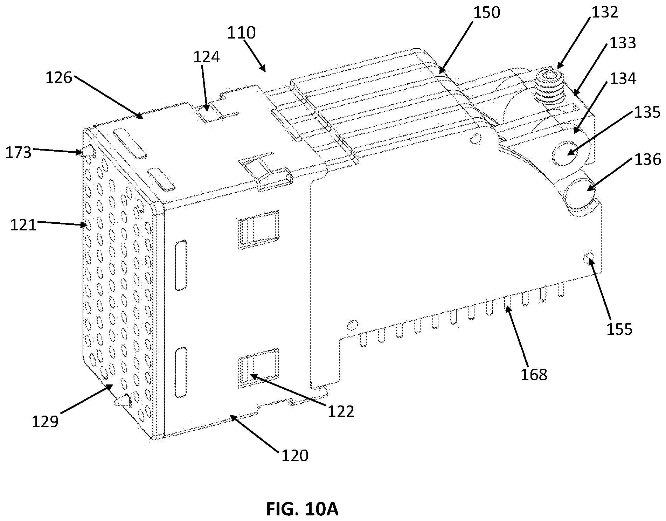

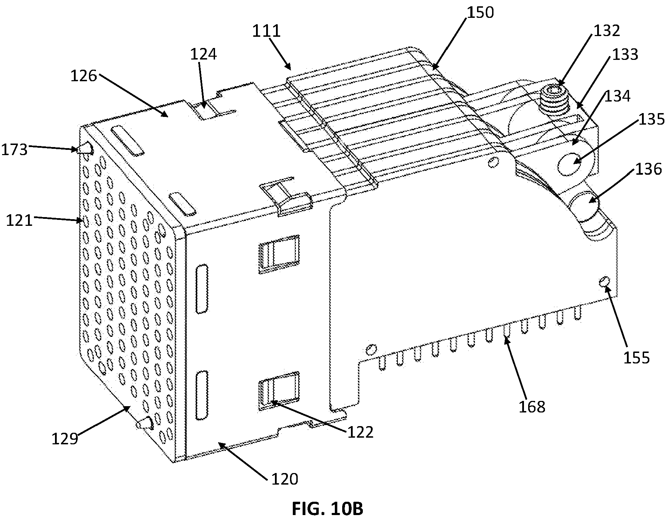

In FIGS. 10A and 10B the single-piece backplane connectors (110) and (111) are shown in perspective view in unmounted and unmated position and several of their features are different from the single-piece backplane connector (10), however the overall function of the devices remains the same as that of the first embodiment. The notable differences are the absence of the EMI shielding housing (40) which for the second embodiment is incorporated into the staggered body assembly (150) and the presence of an integrated locking and offsetting system for the connection with the daughterboard. This offsetting system comprised at least four locking levers (134), at least one locking hinge (133), at least one locking screw (132) and at least one hinge pin (135) which attaches the hinge to the levers and at least one locking screw base (136) which offers positioning and support for the locking screw (132) when the locking and offsetting systems are activated. Further differences related to the blind-mating operation of the connectors (110) and (111) with the backplane PCB (90) are not visible in these two figures but shall be described in continuation.

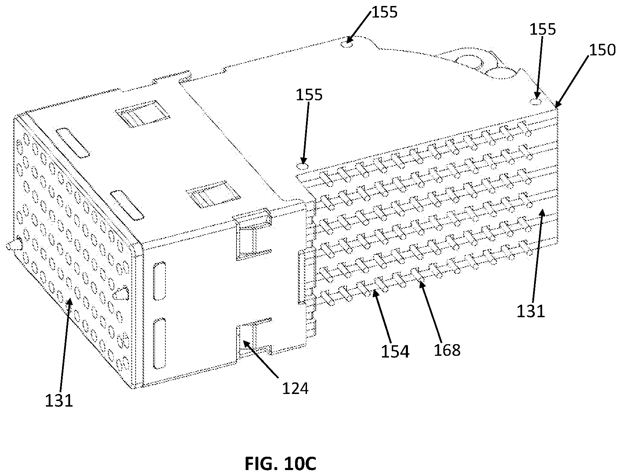

FIG. 10C is a view from a different perspective which makes visible the flat dielectric surfaces (131) which come into contact with the surface of the backplane PCB (90) on the front of the connector and the surface of the daughterboard PCB (80) on the bottom of the connector in conformance with the "double-insulation" requirement present in ESCC specifications related to connectors destined for space-flight applications. At least three installation orifices (155) are provided into the design to support the final mounting of the staggered body assembly (150). A plurality of slide-fit contacts (168) protrudes from the bottom (154) of the staggered body assembly (150).

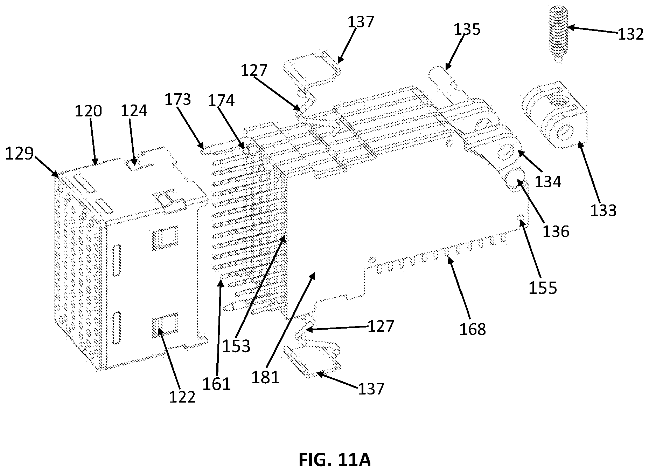

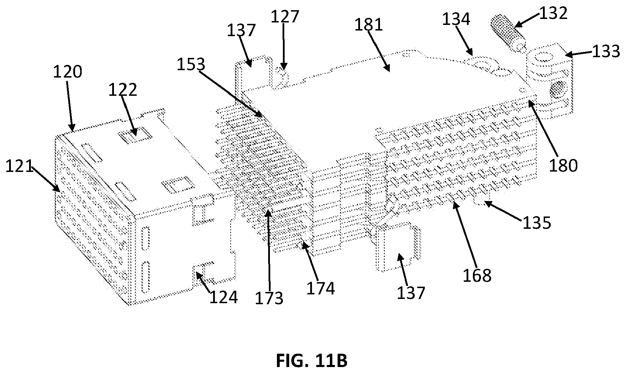

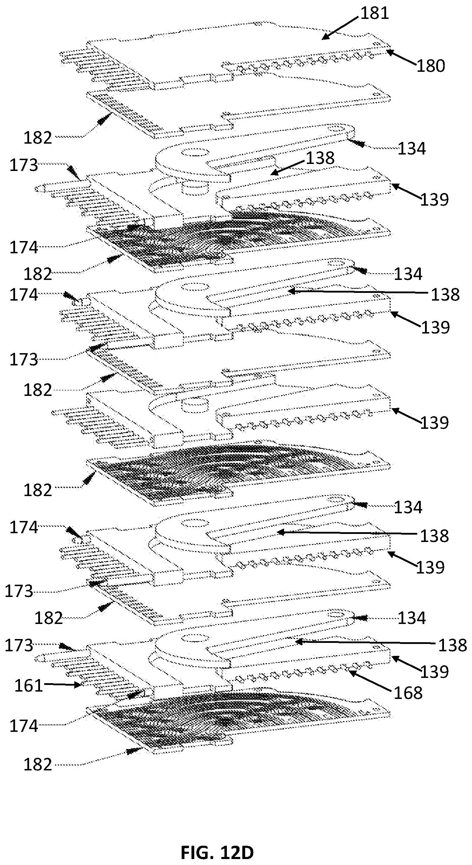

FIGS. 11A and 11B are exploded views of the single-piece connector (110) showing a protective slide-fit cover (120) comprising one or more grounding tabs (122). When fully installed, the grounding tabs (122) provide electrical connection between the protective cover (120) and a ground plane (181) laminated on an end spacer (180), shown in more detail in FIG. 12D. Preferably, the protective slide-fit cover (120) is manufactured from a conductive copper alloy. At least two guide pins (173) and at least two offset pins (174) are installed into a front face (153) of the staggered body assembly (150). Preferably, as illustrated in this embodiment, the offset pins (174) are four offset pins (174). A plurality of slide-fit contacts (161) protrudes from the face (153) of the staggered body assembly (150).

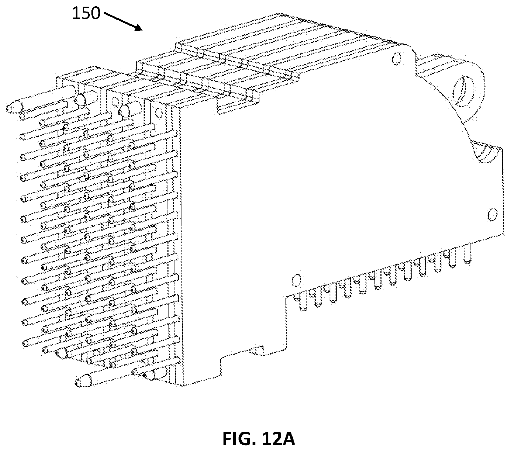

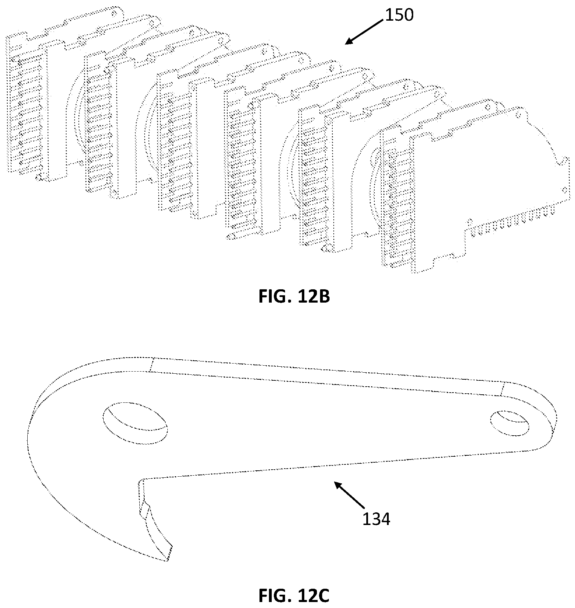

The staggered body assembly (150) of the second embodiment of the single-piece backplane connector is shown assembled in FIG. 12A and disassembled in FIG. 12B, while FIG. 12C shows one exemplary locking lever (134) which is positioned in at least four locations within the staggered body assembly (150) of the single-piece backplane connectors. In FIG. 12D, the detailed configuration of the assembly is shown to demonstrate the unique characteristics of the assembly due to the specific order of the stacked configuration starting from the bottom up with a PCB (182) which contains internally at least two layers of traces and one ground plane, followed by the superimposition of a dielectric spacer (139) which contains at least one ground plane embedded internally and features precise micro-channels routed on its bottom side, as seen in the figure, to house the slide-fit contacts (161) and (168), and on the top side it features a routed housing (138) designed to allow space for the location of the locking lever (134). The stacking order continues with the placement of another PCB (182), followed by another spacer (139) and lever (134) and so on, until the end of the stack. At this end, a special end spacer (180) has an embedded ground plane (not shown), and an external ground plane (181) laminated on its outer surface. As exemplary illustrated, in this staggered assembly (150), some of the dielectric spacers (139) can be fitted with at least one guide pin (173), some of the dielectric spacers (139) can be fitted with at least one offset pin (174) and some of the dielectric spacers (139) can be fitted with one offset pin (174) and one guide pin (173).

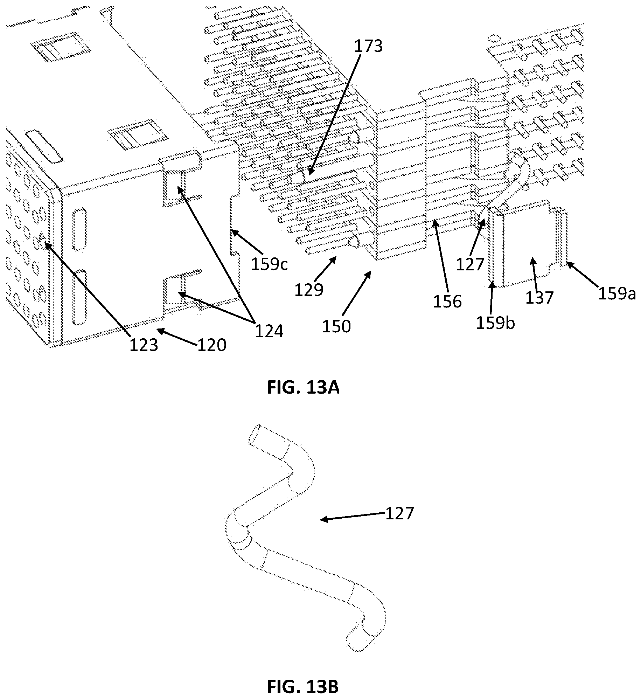

As depicted in FIG. 13 A, once the staggered body assembly (150) is fully completed, the protective slide-fit cover (120) is installed by sliding it over the front face (153) of the staggered body assembly (150) by obtaining alignment between at least two oval guide orifices (123) with the at least two guide pins (173). As the protective cover (120) is being installed, a return spring (127) and a spring clip (137) must be held within a return spring housing (156) on each of both opposite sides of the staggered body assembly (150) as an overlapping cutout (159c) slides over the spring clip (137) trapping within the return spring housing (156) both the return spring (127) and the spring clip (137). As the overlapping cutout (159c) reaches to a spring clip external fold (159a) and accommodates the spring clip external fold (159a), one or more locking tabs (124), which are folded inwards, will lock the protective cover (120) in place by snapping inside the return spring housing (156). The return spring (127) is thereby being held captive by the spring clip which also applies and receives the pressure onto an internal fold (159b). The described spring mechanism is duplicated on the directly opposite side of the body assembly (150) as seen in FIGS. 13A and 13B. The return spring (127) is shown in perspective view in FIG. 13B.

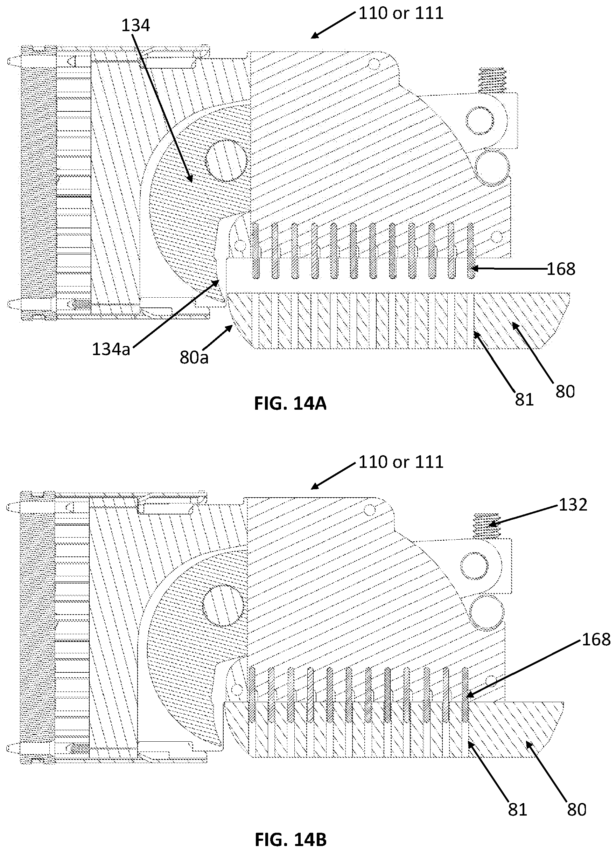

The installation onto the daughterboard PCB (80) of either single-piece backplane connector (110, 111) is similar and is shown on FIGS. 14A to 14C. The requirement for the daughterboard PCB (80) is to feature a rounded edge (80a) on the side where the connectors are mounted. The rounded edge (80a) is accomplished by a precise secondary routing with a radius whose center is positioned on the top surface of the daughterboard PCB (80), the surface which comes in contact with the connector. The resulting rounded edge (80a) on the daughterboard PCB (80) corresponds with the same curvature as a tip curvature (134a) of the locking lever (134). The purpose of the coincidental curvature design between the rounded edge (80a) and the tip curvature (134a) is to permit the same part numbers of connectors (110) or (111) to be installed on daughterboard PCBs (80) of various thickness dimensions, preferably from 1,60mm thickness and greater.

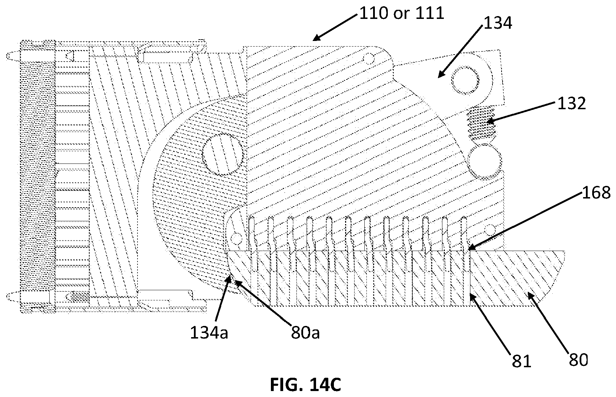

In FIG. 14A the first step of the installation process is shown where the single piece backplane connector (110, 111) is simply visually lined-up with the footprint on the daughterboard PCB (80). The metallized plated through holes (81) are shown lined-up with the slide-fit contacts (168). As depicted in FIG. 14B, the connector is simply dropped into position until slide-fit contacts (168) fully enter the plated through holes (81). Since the outer diameter of slide-fit contacts (168) is slightly smaller than the inner diameter of the plated through holes (81), the insertion is achieved without any resistance therefore no specific insertion tools are required to accomplish the positioning of single-piece backplane connector (110, 111) into daughterboard PCBs (80) of any thickness. Note that the tips of slide-fit contacts (168) do not protrude through the opposite side of the daughterboard PCB (80). Once the single-piece backplane connector (110, 111) is properly in position, the locking screw (132) must be turned clockwise continuously until the lever tip curvature (134a) makes contact with the rounded edge (80a) of the daughterboard PCB (80), and as the locking screw (132) continues to be turned clockwise until the locking lever (134) reaches its maximum "locked" position and consequently the entire connector is pushed towards the left as shown in FIG. 14C. The position displacement achieved by the full activation of the locking lever (134) results in offsetting the slide-fit contacts (168) which work within the elastic deformation characteristic of the base material from which they are manufactured and thereby achieving a reliable electrical connection via the Slide-Fit Electrical Contact Termination interface technology as described on the US Provisional Application No. 63/284,600 which is hereby incorporated by reference in its entirety. The fully locked configuration shown in FIG. 14C demonstrates a novel installation method which achieves full separation of the mechanical locking of the single-piece backplane connector (110, 111) to the daughterboard PCB (80) from the electrical function achieved between the slide-fit contacts (168) and the plated through holes (81) of the daughterboard PCB (80).

Referring to FIG. 9, single-piece backplane connectors (110) and (111) are shown plugged into the backplane PCB (90). In the following paragraphs the blind mating process is described including the functions of each of the corresponding components.

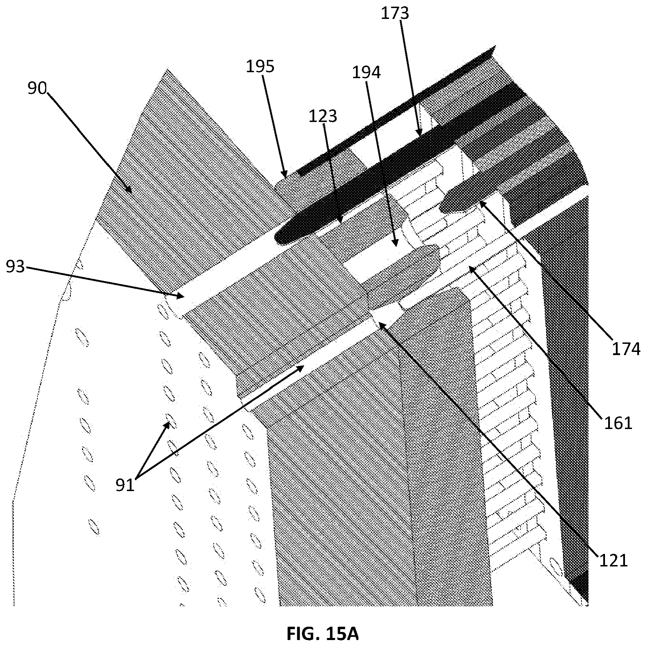

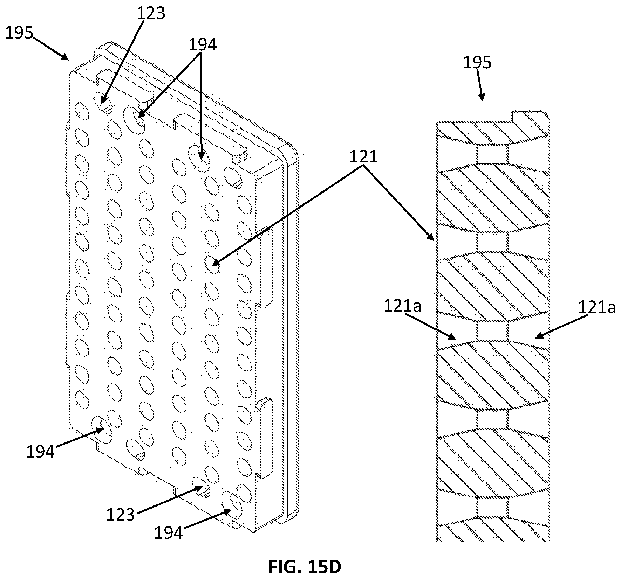

The protective slide-fit cover (120) contains a dielectric offsetting plate (195) shown in FIGS. 15A to 15D. The dielectric offsetting plate (195) includes a plurality of slide-fit contact orifices (121). As shown magnified in FIG. 15D, the cavity profile of the slide-fit contact orifices (121) is confirmed by two opposing conical sections which are elastic deformation zones (121a) for the slide-fit contacts (161). In the illustrated embodiment, the dielectric offsetting plate (195) contains two other types of orifices designed for different functions, the at least two oval guide orifices (123) for the blind mating guide pins (173), and at least four offset guiding orifices (194) for the offset pins (174).

When the daughterboard PCB (80), on which single-piece backplane connectors (110) and (111) are installed, is blind-mated with the backplane PCB (90) as shown in FIG. 9, the single-piece backplane connectors (110) and (111) must have the ability to self-align properly such that the blind-mating operation is executed properly and a good electrical connection is achieved between corresponding electrical positions on daughterboard PCB (80) and backplane PCB (90).

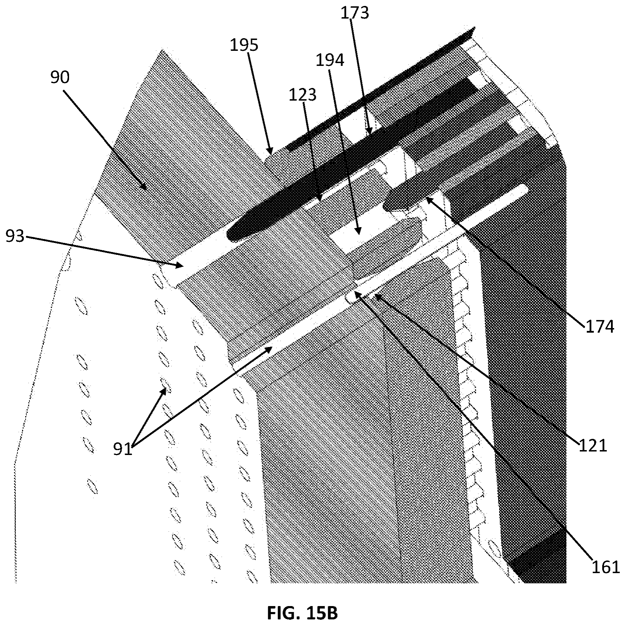

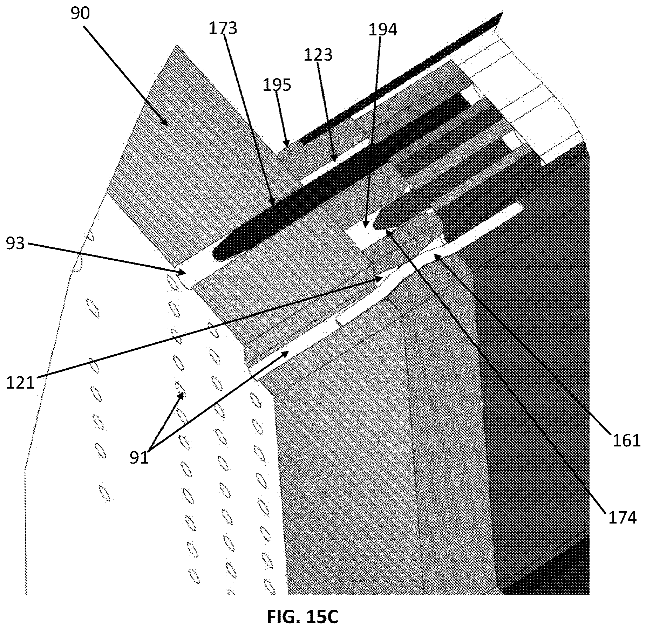

FIGS. 15 A, B and C show a multi-level cross sectional view of the backplane PCB (90), the dielectric offsetting plate (195), the guide pin (173) and the offset pin (174) in such detail which permits to describe the operation of the process.

As depicted in detail in FIGS. 15 A, during the blind-mating process, the alignment of the dielectric offsetting plate (195), with the backplane PCB (90) is achieved when the conical section tips of the guide pins (173), find the guiding orifices (93) in the backplane PCB (90) and align the plurality of orifices (121) which house the slide-fit contacts (161) with the plurality of metalized plated through holes (91) of the backplane PCB (90). When alignment is achieved as shown in FIG. 15 A, the continuation of the plugging action allows the plurality of contacts (161) to advance and start penetrating the plated through holes (91) in the corresponding positions as shown in FIG. 15B. The depth of penetration of contacts (161) into the plated through holes (91) is sufficient to ensure the correct alignment of the connector at the point where the offset pins (174) start to contact the offset guiding orifices (194) from the dielectric offsetting plate (195). It is important to note that the offset pins (174) and the offset guiding orifices (194) are not in alignment, but they are positioned slightly off from each other, yet the conical tip of the offset pin (174) is fully positioned into the conical portion of the offset guiding orifice (194) of the dielectric offsetting plate (195). As the plugging action continues its travel towards achieving the fully mated condition shown in FIG. 15C, the offset pins (174), as they advance, force the dielectric offsetting plate (195) to slightly move sideways perpendicularly to the longitudinal axis of the slide-fit contacts (161). The sideways motion of the dielectric offsetting plate does not disturb the alignment between the guide pins (173) and the backplane PCB (90) because the oval guide orifices (123) permit the offsetting to take place without disturbing the alignment of the daughterboard PCB (80) with the backplane PCB (90) as shown in FIG. 9.

In FIG. 15C the full mated condition is depicted, and the most important aspect is that the slide-fit contact (161) is slightly deformed before the elastic deformation limit of the material is reached such that a good electrical connection is achieved between the slide-fit contact's (161) body and the metalized plated through hole (91) of the backplane PCB (90). The details of operation of the specific electrical interface design between the slide-fit contact (161) and the backplane PCB (90), known as Slide -Fit Electrical Contact Termination Technology, are based on US Provisional Application No. 63/284,600, which is hereby incorporated by reference in its entirety.

The overall configuration of a single-piece backplane connector (110, 111) as described in the second embodiment of this invention offers significant advantages when compared to similar connector products which employ press-fit contact terminations at the interface with PCBs. Press-fit terminations are more damaging to PCBs whereas this invention permits multiple reuses of the same connectors as they do not wear the plating on the surfaces of the interfacing contacts, and they do not wear the plating on the surfaces of the plated holes in the PCB.

The single-piece connector configuration which mates directly with the footprint into a backplane PCB substitutes two different part numbers with one single part number therefore effectively reducing the total cost.

Furthermore, the employment of slide-fit contact termination technology eliminates the need to employ pressing tools and support tools which are required for connectors with press-fit terminations. From the standpoint of signal integrity in high data rate applications, the elimination of an insertion point in the transmission line increases the transfer rate capabilities of the connectors. From an electrical standpoint, the elimination of an insertion points results in the reduction of the total resistance for each line therefore increasing the efficiency of the device.

The ability of the single-piece connector to fully separate the mechanical function of the installation from the electrical function of the contacts, permits the use of such device in harsh environment applications.

In the interface mechanism between the contacts and the plated through holes in the backplane, the electrical function of the connection is also separated from the mechanical function because the mechanical pressure of interface is achieved by the perpendicular force applied on the longitudinal axis of the contacts by the offsetting plate which is held in offset position by the inner offset pins which are manufactured preferably from hard tungsten carbide material to resist shearing forces in applications where high shock and vibration environments are present.

Although the foregoing embodiments have been described in some detail for purposes of clarity of understanding, the disclosed embodiments are illustrative and not restrictive.

## Claims

1. A single-piece backplane connector (10,110) mating its front end with a backplane PCB (90), and mating its bottom with a daughterboard PCB (80), wherein the backplane PCB (90) and daughterboard PCB (80) comprise a plurality of plated through holes (81,91); wherein the single-piece backplane connector (10,110) comprises a protective cover (20,120) slidably attached over a staggered body assembly (50);
wherein the single-piece backplane connector (10,110) is **characterized in that**:
the protective sliding cover (20,120) comprises a plurality of contact orifices (21,121) to permit the path through of a corresponding plurality of pin contacts (61,161) located in a front portion of the staggered body assembly (50,150),
the staggered body assembly (50,150) comprises a plurality of alternating PCB layers (60,182) and dielectric spacers (70,139), wherein the PCB layers (60,182) include a plurality of traces (65), wherein each trace (65) electrically connects each of the pin contacts (61,161) in the front portion of the staggered body assembly (50,150) with a corresponding pin contact (68,168) on the bottom mating with the corresponding plurality of plated through holes in the daughterboard PCB (80);
**characterized in that** the protective sliding cover (20, 120) comprises at least two guide orifices (23,123) to permit the path through of at least two corresponding guide pins (73,173) located in the front portion of the staggered body assembly (50,150); and **in that** the protective sliding cover (20,120) further comprises a return spring mechanism (27,127,137) to allow the protective sliding cover (20,120) to return from a pressed position to a protected unpressed or disconnected position, in which it fully protects the twist pin contacts (61) by shrouding them completely when the connector is uncoupled from the backplane PCB (90), and
wherein, during the mating process of the single-piece backplane connector (10, 110) with the backplane PCB (90), the protective sliding cover (20,120) slides towards the staggered body assembly (50,150) to the pressed position to permit the pin contacts (61,161) to protrude through the orifices (21,121) and to mate with the corresponding plurality of plated through holes (91) in the backplane PCB (90).

2. The single-piece backplane connector in accordance with claim 1, wherein the single-piece backplane connector (10,110) features flat surfaces with the surfaces of the daughterboard PCB (80) and the backplane PCB (90).

3. The single-piece backplane connector in accordance with claim 1, wherein the single-piece backplane connector (10) further comprises an EMI shielding housing (40) fixed to a rear portion of the staggered body assembly (50); wherein the EMI shielding housing (40) comprises: a top surface (46) , a rear wall (49), and two lateral walls (43,44); and wherein each of the lateral walls (43,44) is extended into the daughterboard side (80) by at least one shield tail (48) and at least one installation orifice (45).

4. The single-piece backplane connector in accordance with claim 1, wherein the contact orifices (21) are conformed by a cylindrical portion (21a) in the front face (29) of the protective sliding cover (20) and a conical portion (21b) in the rear face (25) of the protective cover (20).

5. The single-piece backplane connector in accordance with claim 1, wherein the plurality of pin contacts (68,168) mating into the daughterboard is configured in an alternating offset arrangement (52).

6. The single-piece backplane connector in accordance with claim 1, wherein the dielectric spacers (70) comprise a plurality of slots (71,78), wherein each slot (71,78) corresponds to the position of each pin contact (61,68).

7. The single-piece backplane connector in accordance with claim 1, wherein at least two of the dielectric spacers (70) can be fitted with at least one guide pin (73).

8. The single-piece backplane connector in accordance with claim 1, wherein the pin contacts (61,68) have a twist pin contact configuration.

9. The single-piece backplane connector in accordance with claim 1, wherein the return spring mechanism comprises an integrated spring clip (27) to interact with a top and bottom groove (57) of the staggered body assembly (50).

10. The single-piece backplane connector in accordance with claim 1, wherein the staggered body assembly further comprises an offsetting system including: at least four locking levers (134), at least one locking hinge (133), at least one locking screw (132), and at least one hinge pin (135) which attaches the hinge to the levers; and wherein at least one locking screw base (136) to support the locking screw (132).

11. The single-piece backplane connector in accordance to claim 10, wherein the daughterboard PCB (80) comprises a rounded edge (80a) corresponding with a tip curvature (134a) of the locking lever (134).

12. The single-piece backplane connector in accordance to claim 10, wherein the staggered body assembly (150) is configurated in a stack assembly comprising: one PCB layer (182) including at least two layers of traces and one ground plane; followed by one dielectric spacer (139) including at least one ground plane embedded internally, the dielectric spacer comprises micro-channels routed on its bottom side to house the pin contacts (161,168), and on the top side the dielectric spacer further comprises a routed housing (138) to receive the locking lever (134); and wherein the stack assembly configuration continues with another PCB layer (182), followed by another dielectric spacer (139) until the end of the stack; and wherein the staggered body assembly (150) comprises at its end a special end spacer (180) comprising an embedded ground plane and an external ground plane (181) laminated on its outer surface.

13. The single-piece backplane connector in accordance with claim 1, wherein one or more of the dielectric spacers (139) comprise either of at least one guide pin (173), at least one offset pin (174), or one offset pin (174) and one guide pin (173).

14. The single-piece backplane connector in accordance with claim 1, wherein the protective cover (120) further comprises a dielectric offsetting plate (195), and wherein the dielectric offsetting plate (195) comprises a plurality of slide-fit contact orifices (121), at least two oval guide orifices (123), and at least four offset guiding orifices (194), wherein each offset guiding orifice (194) receives an offset pin (174); and wherein the slide-fit contact orifices (121) are conformed by two opposing conical sections which are elastic deformation zones (121a) for the slide-fit contacts (161).

15. The single-piece backplane connector in accordance with claim 1, wherein the return spring mechanism comprises a return spring (127) and a spring clip (137) held within a return spring housing (156) on each of both opposite sides of the staggered body assembly (150) as an overlapping cutout (159c) slides over the spring clip (137) trapping within the return spring housing (156) both the return spring (127) and the spring clip (137); and wherein the overlapping cutout (159c) reaches to a spring clip external fold (159a) and accommodates the spring clip external fold (159a), one or more locking tabs (124) folded inwards to lock the protective cover (120) by snapping inside the return spring housing (156).

## Patentansprüche

1. Einteiliger Backplane-Steckverbinder (10, 110), dessen vorderes Ende mit einer Backplane-Leiterplatte (90) und dessen Unterseite mit einer Tochterplatine (80) verbunden ist, wobei die Backplane-Leiterplatte (90) und die Tochterplatine (80) eine Vielzahl von durchkontaktierten Löchern (81, 91) aufweisen; wobei der einteilige Backplane-Steckverbinder (10, 110) eine Schutzabdeckung (20, 120) umfasst, die verschiebbar über einer versetzten Körperbaugruppe (50) angebracht ist;
wobei der einteilige Backplane-Steckverbinder (10, 110) **dadurch gekennzeichnet ist, dass**:
die schiebbare Schutzabdeckung (20, 120) eine Vielzahl von Kontaktöffnungen (21, 121) umfasst, um den Durchgang einer entsprechenden Vielzahl von Stiftkontakten (61, 161) zu ermöglichen, die sich in einem vorderen Abschnitt der versetzten Körperbaugruppe (50, 150) befinden;
die versetzte Körperanordnung (50, 150) eine Vielzahl von abwechselnden PCB-Schichten (60, 182) und dielektrischen Abstandshaltern (70, 139) umfasst, wobei die PCB-Schichten (60, 182) eine Vielzahl von Leiterbahnen (65) aufweist, wobei jede Leiterbahn (65) jeden der Stiftkontakte (61, 161) im vorderen Abschnitt der versetzten Körperbaugruppe (50, 150) elektrisch mit einem entsprechenden Stiftkontakt (68, 168) an der Unterseite verbindet, der mit der entsprechenden Vielzahl von durchplattierten Löchern in der Tochterplatine (80) zusammenpasst;
**dadurch gekennzeichnet, dass** die schützende Schiebeabdeckung (20, 120) mindestens zwei Führungsöffnungen (23, 123) umfasst, um den Durchgang von mindestens zwei entsprechenden Führungsstiften (73, 173) zu ermöglichen, die sich im vorderen Teil der versetzten Körperbaugruppe (50, 150) befinden;
und dadurch, dass die Schutzschiebeabdeckung (20, 120) ferner einen Rückstellfedermechanismus (27, 127, 137) umfasst, um zu ermöglichen, dass die Schutzschiebeabdeckung (20, 120) aus einer gedrückten Position in eine geschützte, nicht gedrückte oder getrennte Position zurückkehrt, in der sie die Drehstiftkontakte (61) vollständig schützt, indem sie diese vollständig umhüllt, wenn der Steckverbinder von der Rückwandplatine PCB (90) und
wobei während des Steckvorgangs des einteiligen Backplane-Steckverbinders (10, 110) mit der Backplane (90) die schützende Schiebeabdeckung (20, 120) in Richtung der versetzten Baugruppe (50, 150) in die gedrückte Position gleitet, damit die Stiftkontakte (61, 161) durch die Öffnungen (21, 121) ragen und mit der entsprechenden Vielzahl von durchkontaktierten Löchern (91) in der Backplane-Leiterplatte (90) verbunden werden können.

2. Einteiliger Backplane-Steckverbinder gemäß Patentanspruch 1, wobei der einteilige Backplane-Steckverbinder (10, 110) flache Oberflächen mit den Oberflächen der Tochterplatine (80) und der Backplane-Leiterplatte (90) aufweist.

3. Einteiliger Backplane-Steckverbinder gemäß Patentanspruch 1, wobei der einteilige Backplane-Steckverbinder (10) der Anm s zusätzlich ein EMI-Abschirmgehäuse (40) umfasst, das an einem hinteren Abschnitt der versetzten Körperbaugruppe (50) befestigt ist; wobei das EMI-Abschirmgehäuse (40) umfasst: eine Oberseite (46), eine Rückwand (49) und zwei Seitenwände (43, 44); und wobei jede der Seitenwände (43, 44) durch mindestens einen Abschirmungsfortsatz (48) und mindestens eine Einbauöffnung (45) in die Tochterplatinenseite (80) hineinragt.

4. Einteiliger Backplane-Steckverbinder gemäß Patentanspruch 1, wobei die Kontaktöffnungen (21) durch einen zylindrischen Abschnitt (21a) in der Vorderseite (29) der schützenden Schiebeabdeckung (20) und einen konischen Abschnitt (21b) in der Rückseite (25) der Schutzabdeckung (20) gebildet werden.

5. Einteiliger Backplane-Steckverbinder gemäß Patentanspruch 1, wobei die Vielzahl von Stiftkontakten (68, 168), die in die Tochterplatine eingreifen, in einer abwechselnden versetzten Anordnung (52) konfiguriert sind.

6. Einteiliger Backplane-Steckverbinder gemäß Patentanspruch 1, wobei die dielektrischen Abstandshalter (70) mehrere Schlitze (71, 78) aufweisen, wobei jeder Schlitz (71, 78) der Position jedes Stiftkontakts (61, 68) entspricht.

7. Einteiliger Backplane-Steckverbinder gemäß Patentanspruch 1, wobei mindestens zwei der dielektrischen Abstandshalter (70) mit mindestens einem Führungsstift (73) versehen werden können.

8. Einteiliger Backplane-Steckverbinder gemäß Patentanspruch 1, wobei die Stiftkontakte (61, 68) eine verdrillte Stiftkontaktkonfiguration aufweisen.

9. Einteiliger Backplane-Steckverbinder gemäß Patentanspruch 1, wobei der Rückstellfedermechanismus eine integrierte Federklemme (27) umfasst, die mit einer oberen und einer unteren Nut (57) der versetzten Körperbaugruppe (50) zusammenwirkt.

10. Einteiliger Backplane-Steckverbinder gemäß Patentanspruch 1, wobei die versetzte Körperbaugruppe ferner ein Versatzsystem umfasst, das Folgendes umfasst: mindestens vier Verriegelungshebel (134), mindestens ein Verriegelungsscharnier (133), mindestens eine Verriegelungsschraube (132) und mindestens einen Scharnierstift (135), der das Scharnier an den Hebeln befestigt; und wobei mindestens eine Verriegelungsschraubenbasis (136) zum Halten der Verriegelungsschraube (132) vorgesehen ist.

11. Einteiliger Backplane-Steckverbinder gemäß Patentanspruch 10, wobei die Tochterplatine (80) eine abgerundete Kante (80a) aufweist, die einer Spitzen - Krümmung (134a) des Verriegelungshebels (134) entspricht.

12. Einteiliger Backplane-Steckverbinder gemäß Patentanspruch 10, wobei die versetzte Körperbaugruppe (150) in einer Stapelbaugruppe konfiguriert ist, die umfasst: eine Leiterplattenlage (182) mit mindestens zwei Lagen von Leiterbahnen und einer Massefläche; gefolgt von einem dielektrischen Abstandshalter (139) mit mindestens einer intern eingebetteten Grundplatte, wobei der dielektrische Abstandshalter auf seiner Unterseite Mikrokanäle zur Aufnahme der Stiftkontakte (161, 168) aufweist und auf seiner Oberseite einen gefrästen Aufnahmeraum (138) zur Aufnahme des Verriegelungshebels (134) aufweist; und wobei die Stapelbaugruppenkonfiguration mit einer weiteren PCB-Schicht (182) fortgesetzt wird, gefolgt von einem weiteren dielektrischen Abstandshalter (139) bis zum Ende des Stapels; und wobei die versetzte Körperbaugruppe (150) an ihrem Ende einen speziellen Endabstandshalter (180) umfasst, der eine eingebettete Grundplatte und eine externe Grundplatte (181) umfasst, die auf ihre Außenfläche laminiert ist.

13. Einteiliger Backplane-Steckverbinder gemäß Patentanspruch 1, wobei einer oder mehrere der dielektrischen Abstandshalter (139) entweder mindestens einen Führungsstift (173), mindestens einen versetzten Stift (174) oder einen versetzten Stift (174) und einen Führungsstift (173) umfassen.

14. Einteiliger Backplane-Steckverbinder gemäß Patentanspruch 1, wobei die Schutzabdeckung (120) ferner eine dielektrische Versatzplatte (195) umfasst und wobei die dielektrische Versatzplatte (195) eine Vielzahl von Schiebe-Kontaktöffnungen (121), mindestens zwei ovale Führungsöffnungen (123) und mindestens vier versetzte Führungsöffnungen (194) umfasst, wobei jede versetzte Führungsöffnung (194) einen versetzten Stift (174) aufnimmt; und wobei die Schiebe-Kontaktöffnungen (121) durch zwei gegenüberliegende konische Abschnitte gebildet werden, die elastische Verformungszonen (121a) für die Schiebe-Kontakte (161)

15. Einteiliger Backplane-Steckverbinder gemäß Patentanspruch 1, wobei der Rückstellfedermechanismus eine Rückstellfeder (127) und eine Federklemme (137) umfasst, die in einem Rückstellfedergehäuse (156) auf jeder der beiden gegenüberliegenden Seiten der versetzten Körperbaugruppe (150) gehalten werden, während eine überlappende Aussparung (159c) über die Federklemme gleitet (137) gleitet und sowohl die Rückstellfeder (127) als auch die Federklemme (137) im Rückstellfedergehäuse (156) einklemmt; und wobei die überlappende Aussparung (159c) bis zu einer äußeren Falte (159a) der Federklemme reicht und die äußere Falte (159a) der Federklemme aufnimmt, wobei eine oder mehrere Verriegelungslaschen (124) nach innen gefaltet sind, um die Schutzabdeckung (120) durch Einrasten im Rückstellfedergehäuse (156) zu verriegeln.

## Revendications

1. Connecteur de fond de panier monobloc (10, 110) dont l'extrémité avant s'accouple avec un circuit imprimé de fond de panier (90) et dont la partie inférieure s'accouple avec un circuit imprimé de carte fille (80), dans lequel le circuit imprimé de fond de panier (90) et le circuit imprimé de carte fille (80) comprennent une pluralité de trous métallisés (81, 91) ; dans lequel le connecteur de fond de panier monobloc (10, 110) comprend un couvercle de protection (20, 120) fixé de manière coulissante sur un ensemble de corps décalés (50) ;
dans lequel le connecteur de fond de panier monobloc (10, 110) est **caractérisé en ce que** :
le couvercle coulissant de protection (20, 120) comprend une pluralité d'orifices de contact (21, 121) pour permettre le passage d'une pluralité correspondante de contacts à broches (61, 161) situés dans une partie avant de l'ensemble de corps décalés (50, 150) ;
l'ensemble de corps décalés (50, 150) comprend une pluralité de couches de PCB alternées (60, 182) et d'entretoises diélectriques (70, 139), dans lequel les couches de PCB (60, 182) comprennent une pluralité de pistes (65), chaque piste (65) connectant électriquement chacun des contacts à broches (61, 161) dans la partie avant de l'ensemble de corps décalés (50, 150) à un contact à broche correspondant (68, 168) sur la partie inférieure s'accouplant avec la pluralité correspondante de trous métallisés dans le circuit imprimé de la carte fille (80) ;
**caractérisé en ce que** le couvercle coulissant de protection (20, 120) comprend au moins deux orifices de guidage (23, 123) pour permettre le passage d'au moins deux broches de guidage correspondantes (73, 173) situées dans la partie avant de l'ensemble de corps décalés (50, 150) ;
et **en ce que** le couvercle coulissant de protection (20, 120) comprend en outre un mécanisme à ressort de rappel (27, 127, 137) pour permettre au couvercle coulissant de protection (20, 120) de revenir d'une position enfoncée à une position protégée non enfoncée ou déconnectée, dans laquelle il protège entièrement les contacts à broches torsadées (61) en les recouvrant complètement lorsque le connecteur est découplé du circuit imprimé de fond de panier (90), et
dans lequel, pendant le processus d'accouplement du connecteur de fond de panier monobloc (10, 110) avec le fond de panier (90), le couvercle coulissant de protection (20, 120) coulisse vers l'ensemble de corps décalé (50, 150) jusqu'à la position pressée pour permettre aux contacts à broches (61, 161) de faire saillie à travers les orifices (21, 121) et de s'accoupler avec la pluralité correspondante de trous métallisés (91) dans le circuit imprimé de fond de panier (90).

2. Connecteur de fond de panier monobloc selon la revendication 1, dans lequel le connecteur de fond de panier monobloc (10, 110) présente des surfaces planes avec les surfaces du circuit imprimé de la carte fille (80) et du circuit imprimé du fond de panier (90).

3. Connecteur de fond de panier monobloc selon la revendication 1, dans lequel le connecteur de fond de panier monobloc d' s (10) comprend en outre un boîtier de blindage EMI (40) fixé à une partie arrière de l'ensemble de corps décalés (50) ; dans lequel le boîtier de blindage EMI (40) comprend : une surface supérieure (46), une paroi arrière (49) et deux parois latérales (43, 44) ; et dans lequel chacune des parois latérales (43, 44) s'étend dans le côté de la carte fille (80) par au moins une queue de blindage (48) et au moins un orifice d'installation (45).

4. Connecteur de fond de panier monobloc selon la revendication 1, dans lequel les orifices de contact (21) sont formés par une partie cylindrique (21a) dans la face avant (29) du couvercle coulissant de protection (20) et une partie conique (21b) dans la face arrière (25) du couvercle de protection (20).

5. Connecteur de fond de panier monobloc selon la revendication 1, dans lequel la pluralité de contacts à broches (68, 168) s'accouplant dans la carte fille est configurée selon un agencement décalé alterné (52).

6. Connecteur de fond de panier monobloc selon la revendication 1, dans lequel les entretoises diélectriques (70) comprennent une pluralité de fentes (71, 78), chaque fente (71, 78) correspondant à la position de chaque contact à broche (61, 68).

7. Connecteur de fond de panier monobloc selon la revendication 1, dans lequel au moins deux des entretoises diélectriques (70) peuvent être équipées d'au moins une broche de guidage (73).

8. Connecteur de fond de panier monobloc selon la revendication 1, dans lequel les contacts à broches (61, 68) ont une configuration de contact à broches torsadées.

9. Connecteur de fond de panier monobloc selon la revendication 1, dans lequel le mécanisme à ressort de rappel comprend un clip à ressort intégré (27) destiné à interagir avec une rainure supérieure et inférieure (57) de l'ensemble de corps décalés (50).

10. Connecteur de fond de panier monobloc selon la revendication 1, dans lequel l'ensemble de corps décalés comprend en outre un système de décalage comprenant : au moins quatre leviers de verrouillage (134), au moins une charnière de verrouillage (133), au moins une vis de verrouillage (132) et au moins une goupille de charnière (135) qui fixe la charnière aux leviers ; et dans lequel au moins une base de vis de verrouillage (136) pour supporter la vis de verrouillage (132).

11. Connecteur de fond de panier monobloc selon la revendication 10, dans lequel la carte fille PCB (80) comprend un bord arrondi (80a) correspondant à une courbure d'e de pointe (134a) du levier de verrouillage (134).

12. Connecteur de fond de panier monobloc selon la revendication 10, dans lequel l'ensemble de corps décalés (150) est configuré dans un ensemble empilé comprenant : une couche de carte de circuit imprimé (182) comprenant au moins deux couches de pistes et un plan de masse ; suivie d'une entretoise diélectrique (139) comprenant au moins un plan de masse intégré à l'intérieur, l'entretoise diélectrique comprenant des microcanaux fraisés sur sa face inférieure pour loger les contacts à broches (161, 168), et sur la face supérieure, l'entretoise diélectrique comprenant en outre un logement fraisé (138) pour recevoir le levier de verrouillage (134) ; et dans lequel la configuration d'assemblage empilé se poursuit avec une autre couche de PCB (182), suivie d'une autre entretoise diélectrique (139) jusqu'à la fin de l'empilement ; et dans lequel l'assemblage de corps décalés (150) comprend à son extrémité une entretoise d'extrémité spéciale (180) comprenant un plan de masse intégré et un plan de masse externe (181) laminé sur sa surface extérieure.

13. Connecteur de fond de panier monobloc selon la revendication 1, dans lequel une ou plusieurs des entretoises diélectriques (139) comprennent au moins une broche de guidage (173), au moins une broche décalée (174), ou une broche décalée (174) et une broche de guidage (173).

14. Connecteur de fond de panier monobloc selon la revendication 1, dans lequel le couvercle de protection (120) comprend en outre une plaque de décalage diélectrique (195), et dans lequel la plaque de décalage diélectrique (195) comprend une pluralité d'orifices de contact à ajustement coulissant (121), au moins deux orifices de guidage ovales (123) et au moins quatre orifices de guidage décalés (194), dans lequel chaque orifice de guidage décalé (194) reçoit une broche décalée (174) ; et dans lequel les orifices de contact à ajustement coulissant (121) sont conformés par deux sections coniques opposées qui sont des zones de déformation élastique (121a) pour les contacts à ajustement coulissant (161).

15. Connecteur de fond de panier monobloc selon la revendication 1, dans lequel le mécanisme à ressort de rappel comprend un ressort de rappel (127) et un clip à ressort (137) maintenus dans un boîtier de ressort de rappel (156) sur chacun des deux côtés opposés de l'ensemble de corps décalés (150), tandis qu'une découpe en chevauchement (159c) glisse sur le clip à ressort (137) qui retient à l'intérieur du boîtier de ressort de rappel (156) à la fois le ressort de rappel (127) et le clip à ressort (137) ; et dans lequel la découpe chevauchante (159c) atteint un pli externe (159a) de la pince à ressort et s'adapte au pli externe (159a) de la pince à ressort, une ou plusieurs languettes de verrouillage (124) repliées vers l'intérieur pour verrouiller le couvercle de protection (120) en s'enclenchant à l'intérieur du boîtier de ressort de rappel (156).
